(19) **Europäisches Patentamt European Patent Office Office européen des brevets**

(11) **EP 3 564 338 B1**

(12) **EUROPEAN PATENT SPECIFICATION**

(45) Date of publication and mention of the grant of the patent:
**30.03.2022 Bulletin 2022/13**

(21) Application number: **17885799.1**

(22) Date of filing: **26.12.2017**

(51) International Patent Classification (IPC):
$C09K\ 11/77^{(2006.01)}$  $C01F\ 5/00^{(2006.01)}$
$C01F\ 7/16^{(2022.01)}$  $C01F\ 17/00^{(2020.01)}$
$C01G\ 9/00^{(2006.01)}$  $H01L\ 33/50^{(2010.01)}$

(52) Cooperative Patent Classification (CPC):
**C09K 11/7792; C01F 7/166; C01G 9/006; H01L 33/50;** C01P 2002/52

(86) International application number:
**PCT/JP2017/046746**

(87) International publication number:
**WO 2018/124113 (05.07.2018 Gazette 2018/27)**

(54) **PHOSPHORESCENT FLUORESCENT BODY AND PRODUCTION METHOD THEREFORE, AND PHOSPHORESCENT PRODUCT**

**PHOSPHORESZIERENDER FLUORESZENZKÖRPER UND HERSTELLUNGSVERFAHREN DAFÜR SOWIE PHOSPHORESZIERENDES PRODUKT**

**CORPS FLUORESCENT À ACCUMULATION DE LUMIÈRE AINSI QUE PROCÉDÉ DE FABRICATION DE CELUI-CI, ET ARTICLE À ACCUMULATION DE LUMIÈRE**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2016 JP 2016255439**

(43) Date of publication of application:
**06.11.2019 Bulletin 2019/45**

(73) Proprietor: **National Institute of Advanced Industrial Science and Technology Tokyo 100-8921 (JP)**

(72) Inventors:
- **TSUCHIYA, Tetsuo
  Tsukuba-shi
  Ibaraki 305-8565 (JP)**
- **UZAWA, Yuuko
  Tsukuba-shi
  Ibaraki 305-8565 (JP)**
- **YAMAGUCHI, Iwao
  Tsukuba-shi
  Ibaraki 305-8565 (JP)**

- **NAKAJIMA, Tomohiko
  Tsukuba-shi
  Ibaraki 305-8565 (JP)**
- **HIGA, Takumi
  Toyama-shi
  Toyama 930-1305 (JP)**

(74) Representative: **Hoffmann Eitle Patent- und Rechtsanwälte PartmbB Arabellastraße 30 81925 München (DE)**

(56) References cited:
**WO-A1-2011/155428    CN-A- 101 429 432
CN-A- 101 429 432    JP-A- 2007 126 618
JP-A- 2007 197 493    US-B1- 6 267 911**

- **H RYU ET AL: "Enhancement in Photoluminescence on Mg Substitution in Mg x Sr 1-x Al 2 O 4 : Eu, Nd INTRODUCTION", THE OPEN APPLIED PHYSICS JOURNAL, vol. 2, 1 January 2009 (2009-01-01), pages 1-4, XP055517639,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**(Cont. next page)**

- BARTWAL K S ET AL: "Photoluminescence in Mg"xSr"1"-"xAl"2O"4:Eu^2^+, Nd^3^+and electron-vibrational interaction in the Eu^2^+ 5d states", PHYSICA B: CONDENSED MATTER, ELSEVIER, AMSTERDAM, NL, vol. 404, no. 20, 1 November 2009 (2009-11-01), pages 3440-3444, XP026688437, ISSN: 0921-4526 [retrieved on 2009-05-30]
- BARTWAL K S ET AL: "Preparation and spectroscopic studies of the Mg"xSr"1"-"xAl"2O"4:Eu, Dy (x=0.05-0.25) persistent phosphors", OPTICAL MATERIALS, ELSEVIER SCIENCE PUBLISHERS B.V. AMSTERDAM, NL, vol. 32, no. 10, 1 August 2010 (2010-08-01), pages 1329-1332, XP027208163, ISSN: 0925-3467, DOI: 10.1016/J.OPTMAT.2010.04.018 [retrieved on 2010-05-15]
- FENG YANG ET AL: "Influence of Alkaline Earth Elements (Mg2+, Ca2+, Ba2+) to Luminescent Properties of Long Persistent Phosphors SrA1204:Eu2+, Dy3+", ZHONGGUO-XITU-XUEBAO: JIKAN = JOURNAL OF THE CHINESE RARE EARTH SOCIETY, BEIJING : YEJIN GONGYE CHUBANSHE, CN, vol. 26, no. 5, 1 January 2008 (2008-01-01), pages 561-565, XP009515326, ISSN: 1000-4343
- RYU, H. et al.: "Enhancement in Photoluminescence on Mg Substitution in MgxSrl-xA1204:Eu, Nd", The Open Applied Physics Journal, 1 February 2009 (2009-02-01), pages 1-4, XP055517639,
- BARTWAL K. S. et al.: "Photoluminescence in MgxSrl-xA1204:Eu2+, Nd3+ and electron-vibrational interaction in the Eu2+ 5d states", Physica B, vol. 404, no. 20, 30 May 2009 (2009-05-30) , pages 3440-3444, XP026688437, ISSN: 0921-4526
- BARTWAL, K. S. et al.: "Preparation and spectroscopic studies of the MgxSrl-xA1204:Eu,Dy(x=0.05-0.25) persistent phophors", Optical Materials, vol. 32, no. 10, 1 August 2010 (2010-08-01), pages 1329-1332, XP027208163, ISSN: 0925-3467, DOI: 10.1016/j.optmat.2010.04.018
- YANG FENG et al.: "Influence of Alkaline Earth Elements (Mg2+, Ca2+, Ba2+) to Luminescent Properties of Long Persistent Phosphors SrA1204:Eu2+, Dy3+", Journal of the Chinese Rare Earth Society, vol. 26, no. 5, 2008, pages 561-565, XP009515326, ISSN: 1000-4343

**Description**

Technical Field

The present invention relates to a phosphorescent phosphor, a phosphorescent product including the phosphorescent phosphor, and a method for producing the phosphorescent phosphor.

Background Art

Phosphors that can emit light even after light excitation and thus can have a long afterglow time are known as phosphorescent phosphors (phosphorescent materials). Such a phosphorescent phosphor serves as a leading sign and/or illumination even in a disaster or a power failure, and thus is expected as a material for constructing a safe and secure society.

A phosphorescent material known heretofore, exhibiting a long afterglow, has been a green light-emitting aluminate including not only $SrAl_2O_4$ as a mother crystal, but also europium as an activator and at least one element of the group consisting of cerium, praseodymium, neodymium, samarium, terbium, dysprosium, holmium, erbium, thulium, ytterbium, and lutetium, as a co-activator, in each specific amount (Patent Document 1). A phosphorescent material known, having an afterglow intensity (also referred to as "afterglow brightness" in the present embodiment), adapted for use in outdoors has been $(Sr_{1-a-b-x-y}Mg_aBa_bEu_xDy_y)Al_2O_4$ (a satisfies $0.02 \leq a \leq 0.1$, b satisfies $0.03 \leq b \leq 0.15$, x satisfies $0.001 \leq x \leq 0.04$, y satisfies $0.004 \leq y \leq 0.05$, and (a + b) satisfies $0.08 \leq (a + b) \leq 0.2$) to which magnesium or calcium is added (Patent Document 2). Furthermore, a phosphorescent phosphor known, having an afterglow intensity at a high temperature, has been a material including a small amount of an alkali metal element such as lithium, sodium or potassium (Patent Document 3).

Furthermore, H. Ryu et al. (The Open Applied Physics Journal, 2009, Vol. 2, 1-4) and K.S. Bartwal et al. (Physica B, 2009, 3440-3444), respectively, describe phosphors of the following composition: $Mg_xSr_{1-x}Al_2O_4:Eu_{0.01}Nd_{0.02}$, where x is 0.05, 0.10, 0.15, 0.20 or 0.25. The phosphors are produced in the presence of $B_2O_3$.

K.S. Bartwal (Optical Materials, 2010, Vol. 32, 1329-1332) further report on phosphors of the following composition: $Mg_xSr_{1-x}Al_2O_4:Eu_{0.01}Dy_{0.02}$, where x is 0.05, 0.10, 0.15, 0.20 or 0.25.

F. Yang et al. (Journal of the Chinese Rare Earth Society, 2008, Vol. 26, 561-565) report on phosphors of the following composition: $Sr_{0.96-x}Mg_xAl_2O_4:Eu_{0.02}Dy_{0.02}$, where x has a value of 0, 0.05, 0.1, 0.15, 0.2, 0.3 or 0.4.

In US 6,267,911 B1, phosphors of the formula $M_kAl_2O_4: 2xEu^{2+}, 2yR^{3+}$ are described, where M is an alkaline earth metal, and R is a further rare earth element. A portion of the $Al^{3+}$ may be replaced by a divalent ion, namely $Mg^{2+}$ or $Zn^{2+}$. Furthermore, a portion of the alkaline earth metal $M^{2+}$ may be replaced by a monovalent cation.

Citation List

Patent Document

    Patent Document 1: Japanese Patent No. 2543825
    Patent Document 2: International Publication No. 2011/155428
    Patent Document 3: Japanese Patent No. 4932189

Summary of Invention

Technical Problem

LED illumination techniques have been recently developed from the viewpoint of energy saving, and white light by LED illumination is now predominantly obtained according to a method including exciting YAG (selenium phosphor) with a blue LED light source in a wavelength region around 460 nm, unlike a conventional three-wavelength phosphor with red, blue and green mixed. Accordingly, there is a need for a phosphor that can efficiently absorb light emitted from a light source mainly made of a blue LED.

The aluminate phosphor described in Patent Document 1, however, is low in light absorption in a wavelength region of 430 to 480 nm and thus is not sufficient in luminous brightness and afterglow intensity. The phosphorescent material described in each of Patent Documents 2 and 3 is also low in light absorption in a wavelength region of 430 to 480 nm and is difficult to use in LED illumination.

The present invention has been then made in view of the above problems, and an object thereof is to provide a phosphorescent phosphor that emits light due to excitation light in a wavelength region of 430 to 480 nm and also emits light even after termination of excitation, as well as a phosphorescent product including the phosphorescent phosphor and a method for producing the phosphorescent phosphor.

Solution to Problem

The present inventors have made intensive studies in order to solve the above problems, and as a result, have found that a phosphorescent material having a specific composition formula emits light, preferably exhibits high-brightness white light emission, due to excitation with a light source in a wavelength region of 430 to 480 nm, and continues to emit light, preferably continues to emit light at high brightness, even after termination of excitation, thereby leading to completion of the present invention.

The phosphorescent material of the present invention is defined in the appended claims. It is a phosphorescent phosphor which can overcome the drawbacks of conventional phosphorescent phosphors with respect to absorption of light from an LED light source, which is represented by the following composition formula (1):

$$Sr_{1-a}Mg_bZn_cAl_2O_4; EU_dM_e$$

and which emits light due to excitation light in a wavelength region of 430 to 480 nm. In the formula (1), c satisfies either $c = 0$ or $0.01 \leq c \leq 0.2$, a, b, d, and e satisfy $0.05 \leq a \leq 0.8$, $0.01 \leq b < 0.1$, $0 \leq d \leq 0.2$, and $0 \leq e \leq 0.15$, respectively, furthermore a, b, d, and e satisfy $(b + d + e) < a$ if $c = 0$, and M represents at least one element selected from the group consisting of dysprosium (Dy), samarium (Sm), lanthanum (La), praseodymium (Pr), terbium (Tb), holmium (Ho), thulium (Tm), lutetium (Lu), ytterbium (Yb), erbium (Er), gadolinium (Gd), neodymium (Nd) and cerium (Ce). Herein, Sr represents strontium, Mg represents magnesium, Zn represents zinc, Al represents aluminum, Eu represents europium, and O represents oxygen.

Preferably, the phosphorescent phosphor is excited with a light source of 460 nm, and an afterglow intensity 10 minutes after termination of excitation is 300 mcd/m$^2$ or more.

Preferably, the composition formula (1) of the phosphorescent phosphor is represented by $Sr_{0.89}Mg_{0.04}Al_2O_4;Eu_{0.04}Dy_{0.02}$.

Preferably, the composition formula (1) of the phosphorescent phosphor is represented by $Sr_{0.90}Mg_{0.05}Zn_{0.05}Al_2O_4;Eu_{0.035}Dy_{0.025}$.

Preferably, the composition formula (1) of the phosphorescent phosphor is represented by $Sr_{0.905}Mg_{0.04}Al_2O_4;Eu_{0.10}Dy_{0.03}$.

The present inventors have also found that a method for producing a phosphorescent phosphor, including a step of mixing a raw material including a strontium element, a raw material including a magnesium element, alumina, optionally a raw material including a europium element, and optionally a raw material including at least one element selected from the group consisting of dysprosium, samarium, lanthanum, praseodymium, terbium, holmium, thulium, lutetium, ytterbium, erbium, gadolinium, neodymium and cerium, to provide a mixture, and a step of sintering the mixture in the range from 1200°C to 1700°C; or a method for producing a phosphorescent phosphor, including a step of mixing a raw material including a strontium element, a raw material including a magnesium element, alumina, optionally a raw material including a europium element, optionally a raw material including at least one element selected from the group consisting of dysprosium, samarium, lanthanum, praseodymium, terbium, holmium, thulium, lutetium, ytterbium, erbium, gadolinium, neodymium and cerium, and, a raw material including a zinc element, to provide a mixture, and a step of sintering the mixture in the range from 1200°C to 1700°C, is a production method which can suitably provide, in particular, the phosphorescent material of the present invention, thereby leading to completion of the present invention.

Preferably, boron oxide is also mixed in the mixing in the method for producing a phosphorescent phosphor.

Preferably, a uniformly micronized raw material is used as each of the raw materials in the method for producing a phosphorescent phosphor.

The phosphorescent product of the present invention includes the phosphorescent phosphor of the present invention.

Advantageous Effects of Invention

According to the present invention, there can be provided a phosphorescent phosphor that emits light due to excitation light in a wavelength region of 430 to 480 nm and also emits light even after termination of excitation, as well as a phosphorescent product including the phosphorescent phosphor and a method for producing the phosphorescent phosphor.

Description of Embodiments

(Phosphorescent phosphor)

A phosphorescent phosphor according to the present invention is represented by the following composition formula (1):

$$Sr_{1-a}Mg_bZn_cAl_2O_4;Eu_dM_e \; ... \qquad (1)$$

The phosphorescent phosphor is an oxide-based phosphor.

In the formula (1), M represents at least one element selected from the group consisting of dysprosium (Dy), samarium (Sm), lanthanum (La), praseodymium (Pr), terbium (Tb), holmium (Ho), thulium (Tm), lutetium (Lu), ytterbium (Yb), erbium (Er), gadolinium (Gd), neodymium (Nd) and cerium (Ce) from the viewpoint of formation of the trap level. The element represented by M is preferably dysprosium (Dy) because dysprosium (Dy) has favorable fluorescent intensity and afterglow properties.

In the formula (1), the compositional ratio of Sr, namely, a satisfies $0.05 \leq a \leq 0.8$, preferably $0.06 \leq a \leq 0.3$, more preferably $0.07 \leq a \leq 0.2$ from the viewpoint that favorable fluorescent intensity and afterglow properties are obtained. In addition, $(b + c + d + e) < a \leq 0.18$ is preferably satisfied, $(b + c + d + e) < a \leq 0.16$ is more preferably satisfied, $(b + c + d + e) < a \leq 0.15$ is further preferably satisfied, and $(b + c + d + e) < a \leq 0.13$ is still more preferably satisfied because any deficiency in the stoichiometric composition can be introduced to result in increases in afterglow intensity and afterglow time.

The compositional ratio of Mg, namely, b satisfies $0.01 \leq b < 0.1$, and preferably satisfies $0.03 \leq b \leq 0.09$, more preferably $0.045 \leq b \leq 0.08$, further preferably $0.05 \leq b \leq 0.07$ from the viewpoint that a solid solution of Mg in a Sr site allows the bandgap to be controlled to result in an excellent afterglow intensity. If c satisfies $0.01 \leq c \leq 0.2$, the compositional ratio of Mg is preferably excess to the stoichiometric ratio because excellent afterglow properties are obtained, and in such a case, $a < (b + c + d + e)$ or $a < (b + c + d + e)$ is satisfied and $c < b$ is also satisfied. The compositional ratio of Mg is also preferably deficient to the stoichiometric ratio because an excellent fluorescent intensity is obtained, and in such a case, $a > (b + c + d + e)$ or $a > (b + c + d + e)$ is satisfied and $c < b$ is also satisfied. If $c = 0$, $a > (b + d + e)$ is satisfied.

The compositional ratio of Zn, namely, c satisfies either $c = 0$ or $0.01 \leq c \leq 0.2$, preferably satisfies $0.01 \leq c \leq 0.15$, more preferably $0.02 \leq c \leq 0.1$, further preferably $0.02 \leq c \leq 0.08$, still more preferably $0.03 \leq c \leq 0.06$, yet still more preferably $0.04 \leq c \leq 0.05$ from the viewpoint that a solid solution of a Mg site in Sr and Zn allows the bandgap of a mother crystal to be controlled to result in an excellent afterglow intensity. If c satisfies $0.01 \leq c \leq 0.2$, the compositional ratio of Zn is preferably excess to the stoichiometric ratio because excellent afterglow properties are obtained, and in such a case, $a < (b + c + d + e)$ or $a < (b + c + d + e)$ is satisfied and $d < b$ is also satisfied. If c satisfies $0.01 \leq c \leq 0.2$, the compositional ratio of Zn is also preferably deficient to the stoichiometric ratio because excellent afterglow properties are obtained, and in such a case, $a > (b + c + d + e)$ or $a > (b + c + d + e)$ and $d > b$ is also satisfied.

If both Mg and Zn are included, a phosphorescent phosphor simultaneously having a high afterglow intensity and a long afterglow is obtained. In such a case, a phosphorescent phosphor having a deficiency is more preferable.

In the present embodiment, the rate of decay of the afterglow brightness, determined by the following expression (2), is not particularly limited depending on the intended use, but is preferably 46% or more, more preferably 47% or more, further preferably 48% or more particularly in an application where light emission is needed for a long time. The upper limit is not particularly limited, but is preferably 100%, and may be less than 100%, 60% or less, or 55% or less. A rate of decay, falling within the above range, is preferable because a phosphorescent phosphor having not only an excellent afterglow intensity, but also a long afterglow is obtained.

```
Rate of decay of afterglow brightness (%) =

(Afterglow brightness after 10 minutes/Afterglow

brightness after 5 minutes) × 100 ... (2)
```

The afterglow intensities after 5 minutes and after 10 minutes represent afterglow intensities after 5 minutes and after 10 minutes, respectively, determined by leaving the phosphorescent phosphor to still stand in a dark place for 1 hour and thereafter exciting the phosphorescent phosphor at a wavelength of 460 nm with a light source for 1 minute and terminating the excitation.

The compositional ratio of Eu, namely, d satisfies $0 \leq d \leq 0.2$ from the viewpoint that favorable brightness is achieved, and preferably satisfies $0.005 \leq d \leq 0.15$, more preferably $0.01 \leq d \leq 0.1$, further preferably $0.02 \leq d \leq 0.08$,

still more preferably $0.03 \leq d \leq 0.07$, yet still more preferably $0.035 \leq d \leq 0.06$, most preferably $0.04 \leq d \leq 0.05$ from the viewpoint of the cost and an increase in afterglow intensity after excitation.

The compositional ratio of M, namely, e satisfies $0 \leq e \leq 0.15$, preferably satisfies $0.001 \leq e \leq 0.1$, more preferably $0.005 \leq e \leq 0.07$, further preferably $0.01 \leq e \leq 0.06$, still more preferably $0.015 \leq e \leq 0.05$, yet still more preferably $0.02 \leq e \leq 0.04$ from the viewpoint of control of the trap level and elongation of the afterglow time.

In the formula (1), a, b, d, and e satisfy $(b + d + e) < a$ if $c = 0$; and a, b, c, d, and e preferably satisfy $(b + c + d + e) < a$ if c satisfies $0.01 \leq c \leq 0.2$. In the formula (1), a, b, c, d, and e more preferably satisfy $0 < a - (b + c + d + e) \leq 0.15$, further preferably $0.005 \leq a - (b + c + d + e) \leq 0.13$, still more preferably $0.007 \leq a - (b + c + d + e) \leq 0.1$, yet still more preferably $0.01 \leq a \leq 0.05$ because any deficiency in the stoichiometric composition can be introduced to result in increases in afterglow intensity and afterglow time.

In the formula (1), if c satisfies $0.01 \leq c \leq 0.2$, a, b, c, d, and e preferably satisfy $a < (b + c + d + e)$, more preferably $0 < (b + c + d + e) - a \leq 0.3$, further preferably $0.005 \leq (b + c + d + e) - a \leq 0.2$, still more preferably $0.01 \leq (b + c + d + e) - a \leq 0.15$, yet still more preferably $0.02 \leq (b + c + d + e) - a \leq 0.1$, most preferably $0.021 \leq (b + c + d + e) - a \leq 0.023$ because any deficiency in the stoichiometric composition can be introduced to result in increases in afterglow intensity and afterglow time.

The fluorescent intensity of the phosphorescent phosphor of the present invention is not particularly limited depending on the intended use, and the fluorescent intensity (also referred to as "fluorescent brightness" in the present embodiment) due to excitation at 460 nm is preferably 350 cd/m$^2$ or more, more preferably 400 cd/m$^2$ or more, and is more preferably 450 cd/m$^2$ or more because the phosphorescent phosphor can be used as a phosphor having high brightness.

The afterglow intensity after 10 minutes of the phosphorescent phosphor of the present invention, determined after excitation with a light source of 460 nm and the termination thereof, is not particularly limited depending on the intended use, but is preferably 300 mcd/m$^2$ or more, more preferably 350 mcd/m$^2$ or more. The afterglow intensity is further preferably 400 mcd/m$^2$ or more, still further preferably 450 mcd/m$^2$ or more because the phosphorescent phosphor can be used as a leading sign or illumination having an excellent afterglow intensity even in a disaster or a power failure and/or after turning off the light.

In the present embodiment, a phosphorescent phosphor represented by the composition formula $Sr_{0.89}Mg_{0.04}Al_2O_4;Eu_{0.04}Dy_{0.02}$ is preferable because such a phosphorescent phosphor has high brightness and has long afterglow properties which allow light to continue to be emitted at extremely high brightness even after termination of excitation, and the phosphorescent phosphor is more preferably a phosphor obtained by use of $\gamma$-alumina.

In the present embodiment, a phosphorescent phosphor represented by the composition formula $Sr_{0.90}Mg_{0.05}Zn_{0.05}Al_2O_4;Eu_{0.035}Dy_{0.025}$ is preferable because such a phosphorescent phosphor has high brightness and has long afterglow properties which allow light to continue to be emitted at extremely high brightness even after termination of excitation, and the phosphorescent phosphor is more preferably a phosphor obtained by use of $\gamma$-alumina.

In the present embodiment, a phosphorescent phosphor represented by the composition formula $Sr_{0.905}Mg_{0.04}Al_2O_4;Eu_{0.01}Dy_{0.03}$ is preferable because such a phosphorescent phosphor has long afterglow properties which allow light to continue to be emitted at extremely high brightness after termination of excitation.

(Method for producing phosphorescent phosphor)

A method for producing a phosphorescent phosphor of the present embodiment includes a step of mixing a raw material including a strontium element, a raw material including a magnesium element, alumina (aluminum oxide), optionally a raw material including a europium element, optionally a raw material including at least one element selected from the group consisting of dysprosium, samarium, lanthanum, praseodymium, terbium, holmium, thulium, lutetium, ytterbium, erbium, gadolinium, neodymium and cerium, and, as necessary, a raw material including a zinc element, to provide a mixture, and a step of sintering the mixture in the range from 1200°C to 1700°C.

The phosphorescent phosphor of the present invention can be produced, for example, by dry mixing not using any solvent described below or wet mixing using a solvent without particular limitation. The phosphorescent phosphor can be prepared by using an inorganic compound and a metallic organic compound for precursors, as each of the raw materials. Examples of the inorganic compound include metal carbonate, metal oxide, metal hydroxide, and/or metal oxide hydroxide, and such an inorganic compound is used singly or in combinations of two or more kinds thereof. A raw material appropriately uniformly micronized (into nano-size) by a mortar, or a pulverizer such as a planetary ball mill, a bead mill, a hammer mill, a jet mill or a roller mill is preferable as each of the raw materials from the viewpoint of high crystallization. The raw materials can be mixed to thereby provide a mixture of the raw materials of the phosphorescent phosphor. Herein, the following expression (3) can be used as the index representing uniformity of each of the raw materials.

$$Uniformity = \Sigma Xi|D50 - Di|/D50\Sigma Xi \ldots (3)$$

Here, Xi represents the histogram value of particle i, D50 represents the median size on a volume basis, and Di represents the size of particle i on a volume basis. A higher value of the index means a broader distribution.

Each of the raw materials usually has a uniformity represented by the expression (3), of 0.40 or less, preferably 0.30 or less, more preferably 0.27 or less, further preferably 0.25 or less.

The median size D50 in terms of a statistical value on a volume basis is preferably within the range from 0.01 to 1 $\mu$m from the viewpoint of micronization. The median size D50 in terms of a statistical value on a volume basis can be determined by, for example, a laser diffraction/scattering method.

It is also preferable to use, as such a raw material, a metallic organic compound solution mixed at a predetermined ratio, or a metal oxide synthesized by sintering at multiple stages from the viewpoint of a raw material including a larger amount of a nanoparticle, control of the metal composition, and synthesis of a high-crystalline material.

It is also important for synthesize of the phosphorescent phosphor to not only perform high crystallization and control of the metal composition in a synthesis reaction, but also control the valence of Eu having a mixed atomic valence. A precursor raw material with the inorganic compound and the metallic organic compound mixed as raw materials is effective in terms of the effect of promoting generation of $Eu^{2+}$ due to generation of carbon in the course of sintering. Use of Ar (argon) gas or $N_2$ (nitrogen) gas including hydrogen is preferable for a reduction reaction, and inclusion of carbon and/or an organic material in raw materials is also effective therefor.

Mixing of also boron oxide in mixing of the materials is preferable because a phosphorescent phosphor that emits light due to excitation light in a wavelength region of 430 to 480 nm at high brightness even after termination of excitation is suitably obtained. The content of boron oxide in the mixture is not particularly limited as long as the effects of the present invention are exerted, and the content is preferably 0.1 to 10% by mass, more preferably 1 to 5% by mass based on 100% by mass of the total raw materials in the mixture.

Examples of the aluminum oxide include $\alpha$-alumina, y-alumina and aluminum oxide hydroxide. In particular, $\gamma$-alumina ($\gamma$-aluminum oxide) is preferable because such alumina is sintered as a raw material to thereby provide a phosphor having relatively high brightness and a longer afterglow. Such aluminum oxide is used singly or in combinations of two or more kinds thereof.

Examples of the metallic organic compound include a metallic organic acid salt, $\beta$-diketonate, metal alkoxide, metallic acetate, metal 2-ethylhexanoate, metal acetylacetonate, and metal naphthenate. Any metallic organic compound that can be dissolved in a solvent can be used without any particular limitation. Such a metallic organic compound is used singly or in combinations of two or more kinds thereof.

The solvent is not particularly limited as long as the solvent can dissolve the metallic organic compound, and is preferably at least one selected from the group consisting of methanol, ethanol, propanol, butanol, hexanol, heptanol, ethyl acetate, butyl acetate, toluene, xylene, benzene, acetylacetonate, ethylene glycol and water. A compound containing any metal that cannot be dissolved in the solvent, for example, a solid material such as metal oleate or metal stearate can also be used as the precursor.

Thus, in the case where the method of mixing the raw materials is wet mixing using the solvent, the production method of the present embodiment may include a step of drying the mixture in order to subsequently remove the solvent. In the case where a metallic organic compound or nitrate, containing any metal, is used for the raw materials, the production method of the present embodiment may include a step of removing the solvent and an organic component at a temperature of 500°C or less, after the mixing step.

Next, a step of sintering the resulting mixture at 1200°C or more, preferably 1200°C or more and 1800°C or less, more preferably 1400°C or more and 1700°C or less in terms of high crystal growth and control of the valence of Eu can be undergone to thereby provide a phosphorescent phosphor. In the present embodiment, it is preferable to include a step of sintering the mixture with the change in temperature at multiple stages. Such sintering with the change in temperature at multiple stages is desirable in that long afterglow properties are obtained, because the sintering allows composition deviation and/or generation of an impurity phase due to decomposition evaporation to be more effectively and certainly prevented. Herein, an object to be sintered is more desirably pulverized, mixed and formed into a tablet (pressure forming) between such sintering steps at respective temperatures because composition deviation and/or generation of an impurity phase are/is more effectively and certainly prevented. Herein, it is also effective for obtaining long afterglow properties to perform the sintering with the change in temperature at multiple stages without any pulverizing of an object to be sintered and/or forming thereof into a tablet (pressure forming) between such sintering steps at respective temperatures.

After completion of the sintering step or after any sintering step in the sintering with the change in temperature at multiple stages, preferably after the last sintering step, an object to be sintered (phosphor) can be formed into an appropriate shape to thereby provide a sintered compact (phosphorescent product). The resulting sintered compact can also be appropriately formed into a fine powder, thereby providing a fine powdery phosphorescent phosphor.

The fine powdery phosphorescent phosphor can also be applied to the surface of any of various articles, together with, for example, a solid binder and a liquid medium, and/or mixed with plastics, rubber, vinyl chloride, a synthetic resin, and glass to provide a phosphorescent compact of each color, preferably a red phosphorescent compact or a fluorescent film.

According to the present embodiment, there can be provided a phosphorescent phosphor which not only is excited with a light source in a wavelength region of 430 to 480 nm to thereby emit light, but also has phosphorescent characteristics even after termination of excitation, as well as a phosphorescent product including the phosphorescent phosphor and a method for producing the phosphorescent phosphor.

Thus, the phosphorescent phosphor of the present invention can be suitably applied to an energy-saving LED illumination technique, and can retain the function as a leading sign or illumination even in a disaster or a power failure and/or after turning off the light. As a result, the phosphorescent phosphor of the present invention can be used as an excellent phosphor for a white light emission illumination apparatus, contributing to a safe and secure society.

According to the present embodiment, in particular, the phosphorescent phosphor exhibits high brightness with an excitation light source at about 460 nm which corresponds to the wavelength of a blue LED, and also exhibits high brightness and long afterglow even after the excitation light source is turned off. Thus, the phosphorescent phosphor can be widely used as compared with YAG (selenium-based phosphor) for use in a conventional LED requiring for an excitation light source of 460 nm. For example, the phosphorescent phosphor exhibits high brightness even when excited, and emits light even in a power failure, and thus can be developed to luminaire which can perform safe evacuation guidance.

Furthermore, the phosphorescent phosphor of the present invention can be applied to the surface of any of various articles, and/or mixed with, for example, plastics, rubber, vinyl chloride, a synthetic resin, and glass to provide a compact or a fluorescent film, and thus can be utilized in, for example, road signs, visual displays, accessories, leisure goods, watches, OA equipment, educational equipment, safety signs, and building materials. The phosphorescent phosphor of the present invention can also be used as a fluorescent film of a fluorescent lamp, and thus can be used as a fluorescent lamp excellent in afterglow properties.

Examples

Hereinafter, features of the present invention will be described in more detail based on Examples. It is noted that the following description is to facilitate understanding of the present invention and the present invention is not limited thereto.

<Test methods>

(1) Measurement of fluorescent intensity (brightness, $cd/m^2$) and afterglow intensity (brightness, $mcd/m^2$)

The fluorescent intensity of each of samples obtained was measured by a brightness meter (product name "SR-UA1") manufactured by Topcon Corporation in excitation at a wavelength of 460 nm with a light source manufactured by Asahi Spectra Co., Ltd. (product name "MAX-302") .

First, such a sample was left to still stand in a dark place for 1 hour, and thereafter excited with a light source manufactured by Asahi Spectra Co., Ltd. (product name "MAX-302") at a wavelength of 460 nm for 1 minute, and the excitation was terminated, in measurement of the afterglow intensity. The afterglow intensities after 5 minutes and after 10 minutes from the termination were measured by a brightness meter manufactured by Topcon Corporation (product name "SR-UA1").

<Raw materials>

The following raw materials (reagents) were used in synthesis of each phosphorescent phosphor.

(1) strontium carbonate (manufactured by Rare Metallic Co., Ltd., purity: 99.9%)
(2) $\alpha$-aluminum oxide (manufactured by Rare Metallic Co., Ltd., purity: 99.9%)
(3) $\gamma$-aluminum oxide (manufactured by Rare Metallic Co., Ltd., purity: 99.99%)
(4) magnesium oxide (manufactured by Rare Metallic Co., Ltd., purity: 99.99%)
(5) europium oxide (manufactured by Rare Metallic Co., Ltd., purity: 99.99%)
(6) dysprosium oxide (manufactured by Rare Metallic Co., Ltd., purity: 99.9%)
(7) boron oxide (manufactured by Kojundo Chemical Laboratories Co., Ltd., purity: 99.9%)
(8) yttrium oxide (manufactured by Rare Metallic Co., Ltd., purity: 99.9%)
(9) lanthanum oxide (manufactured by Rare Metallic Co., Ltd., purity: 99.9%)

(10) cerium oxide (manufactured by Rare Metallic Co., Ltd., purity: 99.9%)
(11) praseodymium oxide (manufactured by Rare Metallic Co., Ltd., purity: 99.9%)
(12) neodymium oxide (manufactured by Rare Metallic Co., Ltd., purity: 99.9%)
(13) samarium oxide (manufactured by Rare Metallic Co., Ltd., purity: 99.9%)
(14) gadolinium oxide (manufactured by Rare Metallic Co., Ltd., purity: 99.9%)
(15) terbium oxide (manufactured by Rare Metallic Co., Ltd., purity: 99.9%)
(16) holmium oxide (manufactured by Rare Metallic Co., Ltd., purity: 99.9%)
(17) erbium oxide (manufactured by Rare Metallic Co., Ltd., purity: 99.9%)
(18) thulium oxide (manufactured by Rare Metallic Co., Ltd., purity: 99.9%)
(19) ytterbium oxide (manufactured by Rare Metallic Co., Ltd., purity: 99.9%)
(20) lutetium oxide (manufactured by Rare Metallic Co., Ltd., purity: 99.9%)

(Example 1)

Respective raw materials were weighed so as to be at a compositional ratio of $Sr_{0.90}Mg_{0.03}Al_2O_4;Eu_{0.04}Dy_{0.02}$, boron oxide was further added to the raw materials so as to be in an amount of 1.25% by mass based on 100% by mass of the total raw materials, and the resultant was mixed by use of an automatic mortar for 2 hours, thereby providing a mixture powder. Here, $\alpha$-alumina was used as the aluminum oxide. The respective raw materials were uniformly micronized in advance by a planetary mill. The resulting powder was packed in a sintering board made of alumina, and sintered in an argon-hydrogen mixed gas (amount of argon: 3%) at 1400°C for 3 hours. After the sintering, the resultant was pulverized by a mortar and uniformly mixed to thereby provide a powder, and the powder was further formed into a tablet, thereby providing a phosphor sample.
The fluorescent intensity and the afterglow intensity of the sample were measured. The results are shown in Table 1. In Tables 1 and 2, "Deficient" means the A site of an $AB_2O_4$ spinel structure, having a metal composition deficient to the stoichiometric composition, "Stoichiometric" means the A site and the B site of an $AB_2O_4$ spinel structure, having metal compositions of 1.00 and 2.00, respectively, and "Excess" means the A site of an $AB_2O_4$ spinel structure, having a metal composition excess to the stoichiometric composition.

(Example 2) (Reference Example, not according to the claimed invention)

A sample was prepared in the same manner as in Example 1 except that respective raw materials were weighed so as to be at a compositional ratio of $Sr_{0.90}Mg_{0.04}Al_2O_4;Eu_{0.04}Dy_{0.02}$. The fluorescent intensity and the afterglow intensity of the sample were measured. The results are shown in Table 1.

(Example 3) (Reference Example, not according to the claimed invention)

A sample was prepared in the same manner as in Example 1 except that respective raw materials were weighed so as to be at a compositional ratio of $Sr_{0.90}Mg_{0.05}Al_2O_4;Eu_{0.04}Dy_{0.02}$. The fluorescent intensity and the afterglow intensity of the sample were measured. The results are shown in Table 1.

(Example 4) (Reference Example, not according to the claimed invention)

A sample was prepared in the same manner as in Example 1 except that respective raw materials were weighed so as to be at a compositional ratio of $Sr_{0.90}Mg_{0.06}Al_2O_4;Eu_{0.04}Dy_{0.02}$. The fluorescent intensity and the afterglow intensity of the sample were measured. The results are shown in Table 1.

(Comparative Example 1)

A phosphor sample was obtained as Comparative Example 1 by forming a phosphorescent phosphor having a composition of $SrAl_2O_4;Eu:Dy$ (product name "GLL300FF" manufactured by Nemoto Lumi-materials Co., Ltd.) into a tablet in the same manner as in Example 1. The fluorescent intensity and the afterglow intensity of the sample were measured. The results are shown in Table 1.

(Comparative Example 2)

A phosphor sample was obtained as Comparative Example 2 by forming a phosphorescent phosphor having a composition of $SrAl_2O_4;Eu:Dy$ (product name "GLL300M" manufactured by Nemoto Lumi-materials Co., Ltd.) into a tablet in the same manner as in Example 1. The fluorescent intensity and the afterglow intensity of the sample were measured. The results are shown in Table 1.

(Example 5)

A sample was prepared in the same manner as in Example 1 except that the sintering temperature was 1450°C. The fluorescent intensity and the afterglow intensity of the sample were measured. The results are shown in Table 2.

(Example 6) (Reference Example, not according to the claimed invention)

A sample was prepared in the same manner as in Example 2 except that the sintering temperature was 1450°C. The fluorescent intensity and the afterglow intensity of the sample were measured. The results are shown in Table 2.

(Example 7) (Reference Example, not according to the claimed invention)

A sample was prepared in the same manner as in Example 3 except that the sintering temperature was 1450°C. The fluorescent intensity and the afterglow intensity of the sample were measured. The results are shown in Table 2.

(Example 8) (Reference Example, not according to the claimed invention)

A sample was prepared in the same manner as in Example 4 except that the sintering temperature was 1450°C. The fluorescent intensity and the afterglow intensity of the sample were measured. The results are shown in Table 2.

[Table 1]

| | Composition of phosphor | Fluorescent intensity ($cd/m^2$) | Afterglow intensity (after 5 minutes) ($mcd/m^2$) | Afterglow intensity (after 10 minutes) ($mcd/m^2$) |
|---|---|---|---|---|
| Example 1 | Deficient | 469 | 66.3 | 22.5 |
| Example 2* | Stoichiometric | 474 | 285 | 118 |
| Example 3* | Excess | 351 | 573 | 271 |
| Example 4* | Excess | 390 | 265 | 135 |
| Comparative Example 1 | - | 180 | 127 | 60.6 |
| Comparative Example 2 | - | 316 | 564 | 257 |
| *Reference Example, not according to the claimed invention. | | | | |

[Table 2]

| | Composition of phosphor | Fluorescent intensity ($cd/m^2$) | Afterglow intensity (after 5 minutes) ($mcd/m^2$) | Afterglow intensity (after 10 minutes) ($mcd/m^2$) |
|---|---|---|---|---|
| Example 5 | Deficient | 369 | 384 | 175 |
| Example 6* | Stoichiometric | 401 | 270 | 129 |
| Example 7* | Excess | 503 | 425 | 202 |
| Example 8* | Excess | 457 | 197 | 91.4 |
| *Reference Example, not according to the claimed invention. | | | | |

As clear from the results shown in Tables 1 and 2, the phosphorescent phosphor of the present invention emits light due to excitation light at a wavelength of 460 nm and also emits light even after termination of excitation.

In particular, it can be seen from the results shown in Table 1 that an excess content of Mg results in an enhancement in afterglow properties, based on the following: the phosphorescent phosphor having a stoichiometric composition, of Example 2, having an afterglow intensity after 10 minutes, of 118 mcd/m$^2$, and on the other hand, those including an excess content of Mg, of Examples 3 and 4, having afterglow intensities after 10 minutes, of 271 mcd/m$^2$ and 135 mcd/m$^2$, respectively.

(Example 9) (Reference Example, not according to the claimed invention)

A sample was prepared in the same manner as in Example 6 except that $\gamma$-alumina was used as the aluminum oxide. The fluorescent intensity and the afterglow intensity of the sample were measured. The results, together with the results in Example 6, are shown in Table 3.

[Table 3]

| | Composition of phosphor | Fluorescent intensity (cd/m$^2$) | Afterglow intensity (after 5 minutes) (mcd/m$^2$) | Afterglow intensity (after 10 minutes) (mcd/m$^2$) |
|---|---|---|---|---|
| Example 6* | Stoichiometric | 401 | 270 | 129 |
| Example 9* | Stoichiometric | 311 | 781 | 355 |
| *Reference Example, not according to the claimed invention. | | | | |

It can be seen from the results shown in Table 3 that sintering is made with $\gamma$-alumina to result in remarkable afterglow properties with high brightness, based on the following: the phosphorescent phosphor obtained using $\alpha$-alumina, having an afterglow intensity after 10 minutes, of 129 mcd/m$^2$, and on the other hand, the phosphorescent phosphor obtained using $\gamma$-alumina, having an afterglow intensity after 10 minutes, of 355 mcd/m$^2$.

(Example 10)

A sample was prepared in the same manner as in Example 9 except that respective raw materials were weighed so as to be at a compositional ratio of $Sr_{0.89}Mg_{0.04}Al_2O_4;Eu_{0.04}Dy_{0.02}$. The fluorescent intensity and the afterglow intensity of the sample were measured. The results, together with the results in Example 9, are shown in Table 4.

(Example 11)

A sample was prepared in the same manner as in Example 9 except that respective raw materials were weighed so as to be at a compositional ratio of $Sr_{0.87}Mg_{0.04}Al_2O_4;Eu_{0.04}Dy_{0.02}$. The fluorescent intensity and the afterglow intensity of the sample were measured. The results, together with the results in Example 9, are shown in Table 4.

[Table 4]

| | Composition of phosphor | Fluorescent intensity (cd/m$^2$) | Afterglow intensity (after 5 minutes) (mcd/m$^2$) | Afterglow intensity (after 10 minutes) (mcd/m$^2$) |
|---|---|---|---|---|
| Example 9* | Stoichiometric | 311 | 781 | 355 |
| Example 10 | Deficient | 326 | 1100 | 520 |
| Example 11 | Deficient | 347 | 797 | 361 |
| *Reference Example, not according to the claimed invention. | | | | |

It can be seen from the results shown in Table 4 that a phosphorescent phosphor having a deficiency has afterglow properties at extremely high brightness even in the case of use of $\gamma$-alumina. It can be seen that such brightness means extremely remarkable afterglow properties as compared with those of conventional products, based on the comparison with the results in Comparative Examples shown in Table 1.

(Example 12)

A sample was prepared in the same manner as in Example 9 except that respective raw materials were weighed so as to be at a compositional ratio of $Sr_{0.905}Mg_{0.04}Al_2O_4;Eu_{0.01}Dy_{0.03}$, and the sample was sintered in an atmosphere of 1500°C and $N_2:H_2$ = 97:3, for 5 hours. The fluorescent intensity and the afterglow intensity of the sample were measured. The results are shown in Table 5.

[Table 5]

|  | Composition of phosphor | Fluorescent intensity (cd/m$^2$) | Afterglow intensity (after 5 minutes) (mcd/m$^2$) | Afterglow intensity (after 10 minutes) (mcd/m$^2$) |
|---|---|---|---|---|
| Example 12 | Deficient | 242 | 1130 | 529 |

(Example 13)

A sample was prepared in the same manner as in Example 12 except that respective raw materials were weighed so as to be at a compositional ratio of $Sr_{0.90}Mg_{0.05}Zn_{0.05}Al_2O_4;Eu_{0.035}Dy_{0.025}$, and the sample was sintered in an atmosphere of 1500°C and $N_2:H_2$ = 97:3, for 5 hours. The fluorescent intensity and the afterglow intensity of the sample were measured. The results are shown in Table 6.

(Example 14) (Reference Example, not according to the claimed invention)

A sample was prepared in the same manner as in Example 13 except that respective raw materials were weighed so as to be at a compositional ratio of $Sr_{0.90}Mg_{0.05}Al_2O_4;Eu_{0.035}Dy_{0.025}$. The fluorescent intensity and the afterglow intensity of the sample were measured. The results, together with the results in Example 13, are shown in Table 6.

[Table 6]

|  | Composition of phosphor | Fluorescent intensity (cd/m$^2$) | Afterglow intensity (after 5 minutes) (mcd/m$^2$) | Afterglow intensity (after 10 minutes) (mcd/m$^2$) |
|---|---|---|---|---|
| Example 13 | Excess | 273 | 1020 | 478 |
| Example 14* | Excess | 284 | 603 | 279 |
| *Reference Example, not according to the claimed invention. | | | | |

It can be seen from the results shown in Table 6 that doping with Zn (zinc) results in a phosphorescent phosphor having a high afterglow intensity (brightness).

(Example 15) (Reference Example, not according to the claimed invention)

A sample was prepared in the same manner as in Example 14 except that respective raw materials were weighed so as to be at a compositional ratio of $Sr_{0.91}Mg_{0.03}Al_2O_4;Eu_{0.04}Dy_{0.02}$. The fluorescent intensity and the afterglow intensity of the sample were measured. The results are shown in Table 7.

(Example 16) (Reference Example, not according to the claimed invention)

A sample was prepared in the same manner as in Example 14 except that respective raw materials were weighed so as to be at a compositional ratio of $Sr_{0.88}Mg_{0.06}Al_2O_4;Eu_{0.04}Dy_{0.02}$. The fluorescent intensity and the afterglow intensity of the sample were measured. The results are shown in Table 7.

(Example 17) (Reference Example, not according to the claimed invention)

A sample was prepared in the same manner as in Example 14 except that respective raw materials were weighed so as to be at a compositional ratio of $Sr_{0.85}Mg_{0.09}Al_2O_4{:}Eu_{0.04}Dy_{0.02}$. The fluorescent intensity and the afterglow intensity of the sample were measured. The results are shown in Table 7.

(Comparative Example 3)

A sample was prepared in the same manner as in Example 14 except that respective raw materials were weighed so as to be at a compositional ratio of $Sr_{0.94}Al_2O_4{:}Eu_{0.04}Dy_{0.02}$. The fluorescent intensity and the afterglow intensity of the sample were measured. The results are shown in Table 7.

[Table 7]

|  | Composition of phosphor | Fluorescent intensity ($cd/m^2$) | Afterglow intensity (after 5 minutes) ($mcd/m^2$) | Afterglow intensity (after 10 minutes) ($mcd/m^2$) |
|---|---|---|---|---|
| Example 15* | Stoichiometric | 291 | 703 | 296 |
| Example 16* | Stoichiometric | 346 | 708 | 309 |
| Example 17* | Stoichiometric | 347 | 545 | 241 |
| Comparative Example 2 | - | 316 | 564 | 257 |
| Comparative Example 3 | - | 291 | 504 | 223 |
| *Reference Example, not according to the claimed invention. | | | | |

It can be seen from the results shown in Table 7 that doping with Mg results in excellent fluorescent intensity and afterglow intensity with respect to excitation light at a wavelength of 460 nm, based on the following: the fluorescent intensity and the afterglow intensity in each of Examples 15 to 17 being excellent as compared with those in Comparative Example 3. It can also be seen that the compositional ratio of Mg, namely, b satisfies $0.01 \leq b < 0.1$ to result in excellent fluorescent intensity and afterglow intensity, based on the following: the afterglow intensity in Example 17 being inferior as compared with the afterglow intensity in Comparative Example 2, but the fluorescent intensity in Example 17 being higher than not only the fluorescent intensity in Comparative Example 2, but also those in Examples 15 and 16.

(Comparative Example 4)

A sample was prepared in the same manner as in Example 1 except that respective raw materials were weighed so as to be at a compositional ratio of $Sr_{0.94}Mg_{0.02}Al_2O_4{:}Y_{0.04}$ and the sintering was made at a sintering temperature of 1300°C. The fluorescent intensity and the afterglow intensity of the sample were measured. The results are shown in Table 8. Herein, Y represents yttrium.

(Comparative Example 5)

A sample was prepared in the same manner as in Example 1 except that respective raw materials were weighed so as to be at a compositional ratio of $Sr_{0.94}Mg_{0.02}Al_2O_4{:}La_{0.04}$ and the sintering was made at a sintering temperature of 1300°C. The fluorescent intensity and the afterglow intensity of the sample were measured. The results are shown in Table 8.

(Comparative Example 6)

A sample was prepared in the same manner as in Example 1 except that respective raw materials were weighed so as to be at a compositional ratio of $Sr_{0.94}Mg_{0.02}Al_2O_4{:}Ce_{0.04}$ and the sintering was made at a sintering temperature of 1300°C. The fluorescent intensity and the afterglow intensity of the sample were measured. The results are shown in Table 8.

(Comparative Example 7)

A sample was prepared in the same manner as in Example 1 except that respective raw materials were weighed so as to be at a compositional ratio of $Sr_{0.94}Mg_{0.02}Al_2O_4;Pr_{0.04}$ and the sintering was made at a sintering temperature of 1300°C. The fluorescent intensity and the afterglow intensity of the sample were measured. The results are shown in Table 8.

(Comparative Example 8)

A sample was prepared in the same manner as in Example 1 except that respective raw materials were weighed so as to be at a compositional ratio of $Sr_{0.94}Mg_{0.02}Al_2O_4;Nd_{0.04}$ and the sintering was made at a sintering temperature of 1300°C. The fluorescent intensity and the afterglow intensity of the sample were measured. The results are shown in Table 8.

(Comparative Example 9)

A sample was prepared in the same manner as in Example 1 except that respective raw materials were weighed so as to be at a compositional ratio of $Sr_{0.94}Mg_{0.02}Al_2O_4;Sm_{0.04}$ and the sintering was made at a sintering temperature of 1300°C. The fluorescent intensity and the afterglow intensity of the sample were measured. The results are shown in Table 8.

(Comparative Example 10)

A sample was prepared in the same manner as in Example 1 except that respective raw materials were weighed so as to be at a compositional ratio of $Sr_{0.94}Mg_{0.02}Al_2O_4;Eu_{0.04}$ and the sintering was made at a sintering temperature of 1300°C. The fluorescent intensity and the afterglow intensity of the sample were measured. The results are shown in Table 8. Herein, Eu represents europium.

(Comparative Example 11)

A sample was prepared in the same manner as in Example 1 except that respective raw materials were weighed so as to be at a compositional ratio of $Sr_{0.94}Mg_{0.02}Al_2O_4;Gd_{0.04}$ and the sintering was made at a sintering temperature of 1300°C. The fluorescent intensity and the afterglow intensity of the sample were measured. The results are shown in Table 8.

(Comparative Example 12)

A sample was prepared in the same manner as in Example 1 except that respective raw materials were weighed so as to be at a compositional ratio of $Sr_{0.94}Mg_{0.02}Al_2O_4;Tb_{0.04}$ and the sintering was made at a sintering temperature of 1300°C. The fluorescent intensity and the afterglow intensity of the sample were measured. The results are shown in Table 8.

(Comparative Example 13)

A sample was prepared in the same manner as in Example 1 except that respective raw materials were weighed so as to be at a compositional ratio of $Sr_{0.94}Mg_{0.02}Al_2O_4;Dy_{0.04}$ and the sintering was made at a sintering temperature of 1300°C. The fluorescent intensity and the afterglow intensity of the sample were measured. The results are shown in Table 8.

(Comparative Example 14)

A sample was prepared in the same manner as in Example 1 except that respective raw materials were weighed so as to be at a compositional ratio of $Sr_{0.94}Mg_{0.02}Al_2O_4;Ho_{0.04}$ and the sintering was made at a sintering temperature of 1300°C. The fluorescent intensity and the afterglow intensity of the sample were measured. The results are shown in Table 8.

(Comparative Example 15)

A sample was prepared in the same manner as in Example 1 except that respective raw materials were weighed so as to be at a compositional ratio of $Sr_{0.94}Mg_{0.02}Al_2O_4;Er_{0.04}$ and the sintering was made at a sintering temperature of 1300°C. The fluorescent intensity and the afterglow intensity of the sample were measured. The results are shown in Table 8.

(Comparative Example 16)

A sample was prepared in the same manner as in Example 1 except that respective raw materials were weighed so as to be at a compositional ratio of $Sr_{0.94}Mg_{0.02}Al_2O_4;Tm_{0.04}$ and the sintering was made at a sintering temperature of 1300°C. The fluorescent intensity and the afterglow intensity of the sample were measured. The results are shown in Table 8.

(Comparative Example 17)

A sample was prepared in the same manner as in Example 1 except that respective raw materials were weighed so as to be at a compositional ratio of $Sr_{0.94}Mg_{0.02}Al_2O_4;Yb_{0.04}$ and the sintering was made at a sintering temperature of 1300°C. The fluorescent intensity and the afterglow intensity of the sample were measured. The results are shown in Table 8.

(Comparative Example 18)

A sample was prepared in the same manner as in Example 1 except that respective raw materials were weighed so as to be at a compositional ratio of $Sr_{0.94}Mg_{0.02}Al_2O_4;Lu_{0.04}$ and the sintering was made at a sintering temperature of 1300°C. The fluorescent intensity and the afterglow intensity of the sample were measured. The results are shown in Table 8.

[Table 8]

| | Fluorescent intensity (cd/m$^2$) | Afterglow intensity (after 5 minutes) (mcd/m$^2$) | Afterglow intensity (after 10 minutes) (mcd/m$^2$) |
|---|---|---|---|
| Comparative Example 4 | 129.2 | 2.89 | 1.26 |
| Comparative Example 5 | 134.8 | 2.98 | 1.51 |
| Comparative Example 6 | 69.0 | 0.25 | 0.16 |
| Comparative Example 7 | 115.5 | 0.42 | 0.21 |
| Comparative Example 8 | 127.5 | 0.98 | 0.63 |
| Comparative Example 9 | 106.6 | 0.3 | 0.32 |
| Comparative Example 10 | 511.6 | 15.6 | 6.84 |
| Comparative Example 11 | 123.1 | 2.34 | 1.31 |
| Comparative Example 12 | 133.5 | 0.24 | 0.25 |
| Comparative Example 13 | 123.3 | 1.86 | 0.85 |

(continued)

|  | Fluorescent intensity (cd/m$^2$) | Afterglow intensity (after 5 minutes) (mcd/m$^2$) | Afterglow intensity (after 10 minutes) (mcd/m$^2$) |
|---|---|---|---|
| Comparative Example 14 | 115.8 | 0.79 | 0.44 |
| Comparative Example 15 | 130.4 | 0.43 | 0.13 |
| Comparative Example 16 | 120.8 | 1.05 | 0.55 |
| Comparative Example 17 | 117.4 | 0.39 | 0.3 |
| Comparative Example 18 | 135.4 | 0.62 | 0.48 |

It can be seen from the results shown in Table 8 that doping with only rare earth does not impart any excellent fluorescent intensity and afterglow intensity of the phosphorescent phosphor of the present invention.

(Example 18)

A sample was prepared in the same manner as in Example 1 except that $\gamma$-alumina was used as the aluminum oxide and respective raw materials were weighed so as to be at a compositional ratio of $Sr_{0.89}Mg_{0.03}Zn_{0.03}Al_2O_4{:}Eu_{0.02}Dy_{0.03}$. The fluorescent intensity and the afterglow intensity of the sample were measured. The results are shown in Table 9.

(Example 19)

A sample was prepared in the same manner as in Example 1 except that $\gamma$-alumina was used as the aluminum oxide and respective raw materials were weighed so as to be at a compositional ratio of $Sr_{0.88}Mg_{0.03}Zn_{0.03}Al_2O_4{:}Eu_{0.02}Dy_{0.03}$. The fluorescent intensity and the afterglow intensity of the sample were measured. The results are shown in Table 9.

[Table 9]

|  | Composition of phosphor | Fluorescent intensity (cd/m$^2$) | Afterglow intensity (after 5 minutes) (mcd/m$^2$) | Afterglow intensity (after 10 minutes) (mcd/m$^2$) |
|---|---|---|---|---|
| Example 18 | Stoichiometric | 251 | 719 | 334 |
| Example 19 | Deficient | 247 | 984 | 481 |

It can be seen from the results shown in Table 9 that doping with Zn results in a phosphorescent phosphor having a high afterglow intensity.

(Example 20)

A sample was prepared in the same manner as in Example 1 except that $\gamma$-alumina was used as the aluminum oxide and respective raw materials were weighed so as to be at a compositional ratio of $Sr_{0.89}Mg_{0.04}Zn_{0.01}Al_2O_4{:}Eu_{0.02}Dy_{0.03}$. The fluorescent intensity and the afterglow intensity of the sample were measured. The results are shown in Table 10.

(Example 21)

A sample was prepared in the same manner as in Example 1 except that $\gamma$-alumina was used as the aluminum oxide and respective raw materials were weighed so as to be at a compositional ratio of $Sr_{0.88}Mg_{0.04}Zn_{0.02}Al_2O_4;Eu_{0.02}Dy_{0.03}$. The fluorescent intensity and the afterglow intensity of the sample were measured. The results are shown in Table 10.

(Example 22)

A sample was prepared in the same manner as in Example 1 except that $\gamma$-alumina was used as the aluminum oxide and respective raw materials were weighed so as to be at a compositional ratio of $Sr_{0.87}Mg_{0.04}Zn_{0.03}Al_2O_4;Eu_{0.02}Dy_{0.03}$. The fluorescent intensity and the afterglow intensity of the sample were measured. The results are shown in Table 10.

(Example 23)

A sample was prepared in the same manner as in Example 1 except that $\gamma$-alumina was used as the aluminum oxide and respective raw materials were weighed so as to be at a compositional ratio of $Sr_{0.86}Mg_{0.04}Zn_{0.04}Al_2O_4;Eu_{0.02}Dy_{0.03}$. The fluorescent intensity and the afterglow intensity of the sample were measured. The results are shown in Table 10.

(Example 24)

A sample was prepared in the same manner as in Example 1 except that $\gamma$-alumina was used as the aluminum oxide and respective raw materials were weighed so as to be at a compositional ratio of $Sr_{0.845}Mg_{0.03}Zn_{0.06}Al_2O_4;Eu_{0.15}Dy_{0.03}$. The fluorescent intensity and the afterglow intensity of the sample were measured. The results are shown in Table 10.

(Example 25)

A sample was prepared in the same manner as in Example 1 except that $\gamma$-alumina was used as the aluminum oxide and respective raw materials were weighed so as to be at a compositional ratio of $Sr_{0.855}Mg_{0.03}Zn_{0.07}Al_2O_4;Eu_{0.15}Dy_{0.03}$. The fluorescent intensity and the afterglow intensity of the sample were measured. The results are shown in Table 10.

[Table 10]

| | Fluorescent intensity (cd/m$^2$) | Afterglow intensity (after 5 minutes) (mcd/m$^2$) | Afterglow intensity (after 10 minutes) (mcd/m$^2$) |
|---|---|---|---|
| Example 20 | 284 | 533 | 250 |
| Example 21 | 261 | 495 | 236 |
| Example 22 | 275 | 1138 | 548 |
| Example 23 | 282 | 1012 | 484 |
| Example 24 | 260 | 821 | 399 |
| Example 25 | 254 | 936 | 449 |

It can be seen from the results shown in Table 10 that doping with Zn results in a phosphorescent phosphor having a high afterglow intensity.

(Example 26)

A sample was prepared in the same manner as in Example 1 except that $\gamma$-alumina was used as the aluminum oxide and respective raw materials were weighed so as to be at a compositional ratio of $Sr_{0.88}Mg_{0.03}Zn_{0.03}Al_2O_4;Eu_{0.02}Dy_{0.03}$. The fluorescent intensity and the afterglow intensity of the sample were measured. The results are shown in Table 11.

(Example 27)

A sample was prepared in the same manner as in Example 1 except that γ-alumina was used as the aluminum oxide and respective raw materials were weighed so as to be at a compositional ratio of $Sr_{0.87}Mg_{0.04}Zn_{0.03}Al_2O_4{:}Eu_{0.02}Dy_{0.03}$. The fluorescent intensity and the afterglow intensity of the sample were measured. The results are shown in Table 11.

(Example 28)

A sample was prepared in the same manner as in Example 1 except that γ-alumina was used as the aluminum oxide and respective raw materials were weighed so as to be at a compositional ratio of $Sr_{0.86}Mg_{0.05}Zn_{0.03}Al_2O_4{:}Eu_{0.02}Dy_{0.03}$. The fluorescent intensity and the afterglow intensity of the sample were measured. The results are shown in Table 11.

[Table 11]

|  | Fluorescent intensity (cd/m$^2$) | Afterglow intensity (after 5 minutes) (mcd/m$^2$) | Afterglow intensity (after 10 minutes) (mcd/m$^2$) |
|---|---|---|---|
| Example 26 | 247 | 984 | 481 |
| Example 27 | 275 | 1138 | 549 |
| Example 28 | 298 | 935 | 455 |

The rate of decay of the afterglow brightness was determined with respect to the samples in Comparative Example 2, and Examples 10 and 26 to 28, according to the following expression (3). The results are shown in Table 12.

$$\text{Rate of decay of afterglow brightness (\%) =}$$
$$\text{Afterglow brightness (after 10 minutes)/Afterglow}$$
$$\text{brightness (after 5 minutes)} \times 100 \ ... \ (3)$$

[Table 12]

|  | Rate of decay of afterglow brightness (%) |
|---|---|
| Comparative Example 2 | 45.5 |
| Example 10 | 47.3 |
| Example 26 | 48.9 |
| Example 27 | 48.2 |
| Example 28 | 48.7 |

It can be seen from the results shown in Tables 11 and 12 that doping with Zn and Mg results in a phosphorescent phosphor simultaneously having a high afterglow intensity and a long afterglow.

Industrial Applicability

The phosphorescent phosphor of the present invention can be widely applied to, for example, illumination apparatuses for road signs, safety signs, and visual displays, and illumination techniques using LEDs, such as accessories, leisure goods, watches, OA equipment, educational equipment and building materials.

**Claims**

1. A phosphorescent phosphor represented by the following composition formula (1):

$$Sr_{1-a}Mg_bAl_2O_4;Eu_dM_e \ ... \qquad (1)$$

wherein a, b, d, and e satisfy $(b + d + e) < a$, $0.05 \leq a \leq 0.8$, $0.01 \leq b < 0.1$, $0 \leq d \leq 0.2$, and $0 \leq e \leq 0.15$, respectively, and M represents at least one element selected from the group consisting of dysprosium, samarium, lanthanum, praseodymium, terbium, holmium, thulium, lutetium, ytterbium, erbium, gadolinium, neodymium and cerium;
wherein the phosphorescent phosphor emits light due to excitation light in a wavelength region of 430 to 480 nm.

2. A phosphorescent phosphor represented by the following composition formula (1):

$$Sr_{1-a}Mg_bZn_cAl_2O_4;Eu_dM_e \ ... \qquad (1)$$

wherein a, b, c, d, and e satisfy $0.05 \leq a \leq 0.8$, $0.01 \leq b < 0.1$, $0.01 \leq c \leq 0.2$, $0 \leq d \leq 0.2$, and $0 \leq e \leq 0.15$, respectively, and M represents at least one element selected from the group consisting of dysprosium, samarium, lanthanum, praseodymium, terbium, holmium, thulium, lutetium, ytterbium, erbium, gadolinium, neodymium and cerium;
wherein the phosphorescent phosphor emits light due to excitation light in a wavelength region of 430 to 480 nm.

3. The phosphorescent phosphor according to claim 1, represented by $Sr_{0.89}Mg_{0.04}Al_2O_4;Eu_{0.04}Dy_{0.02}$.

4. The phosphorescent phosphor according to claim 2, represented by $Sr_{0.90}Mg_{0.05}Zn_{0.05}Al_2O_4;Eu_{0.035}Dy_{0.025}$.

5. The phosphorescent phosphor according to claim 1, represented by $Sr_{0.905}Mg_{0.04}Al_2O_4;Eu_{0.01}Dy_{0.03}$.

6. A method for producing the phosphorescent phosphor according to any one of claims 1, 3 and 5, the method comprising:

   a step of mixing a raw material comprising a strontium element, a raw material comprising a magnesium element, alumina, optionally a raw material comprising a europium element, and optionally a raw material comprising at least one element selected from the group consisting of dysprosium, samarium, lanthanum, praseodymium, terbium, holmium, thulium, lutetium, ytterbium, erbium, gadolinium, neodymium and cerium, to provide a mixture; and
   a step of sintering the mixture in a range from 1200°C to 1700°C.

7. A method for producing the phosphorescent phosphor according to any one of claims 2 and 4, the method comprising:

   a step of mixing a raw material comprising a strontium element, a raw material comprising a magnesium element, alumina, optionally a raw material comprising a europium element, optionally a raw material comprising at least one element selected from the group consisting of dysprosium, samarium, lanthanum, praseodymium, terbium, holmium, thulium, lutetium, ytterbium, erbium, gadolinium, neodymium and cerium, and a raw material comprising a zinc element, to provide a mixture; and
   a step of sintering the mixture in a range from 1200°C to 1700°C.

8. The method for producing the phosphorescent phosphor according to claim 6 or 7, wherein boron oxide is also mixed in the step of providing the mixture.

9. A phosphorescent product comprising the phosphorescent phosphor according to any one of claims 1 to 5.


**Patentansprüche**

1. Phosphoreszierender Leuchtstoff, dargestellt durch die folgende Zusammensetzungsformel (1):

$$Sr_{1-a}Mg_bAl_2O_4;EU_dM_e \ ... \qquad (1)$$

worin a, b, d und e (b + d + e) < a, 0,05 $\leq$ a $\leq$ 0,8, 0,01 b < 0,1, 0 $\leq$ d $\leq$ 0,2 beziehungsweise 0 $\leq$ e $\leq$ 0,15 erfüllen, und M für mindestens ein Element steht, das aus der Gruppe ausgewählt ist, die aus Dysprosium, Samarium, Lanthan, Praseodym, Terbium, Holmium, Thulium, Lutetium, Ytterbium, Erbium, Gadolinium, Neodym und Cer besteht; wobei der phosphoreszierende Leuchtstoff aufgrund von Anregungslicht Licht in einem Wellenlängenbereich von 430 bis 480 nm emittiert.

2. Phosphoreszierender Leuchtstoff, dargestellt durch die folgende Zusammensetzungsformel (1):

$$Sr_{1-a}Mg_bZn_cAl_2O_4{:}Eu_dM_e ... \qquad (1)$$

worin a, b, c, d und e 0,05 $\leq$ a $\leq$ 0,8, 0,01 $\leq$ b < 0,1, 0,01 $\leq$ c $\leq$ 0,2, 0 $\leq$ d $\leq$ 0,2 beziehungsweise 0 $\leq$ e $\leq$ 0,15 erfüllen, und M für mindestens ein Element steht, das aus der Gruppe ausgewählt ist, die aus Dysprosium, Samarium, Lanthan, Praseodym, Terbium, Holmium, Thulium, Lutetium, Ytterbium, Erbium, Gadolinium, Neodym und Cer besteht; wobei der phosphoreszierende Leuchtstoff aufgrund von Anregungslicht Licht in einem Wellenlängenbereich von 430 bis 480 nm emittiert.

3. Phosphoreszierender Leuchtstoff gemäß Anspruch 1, dargestellt durch $Sr_{0,89}Mg_{0,04}Al_2O_4{:}Eu_{0,04}Dy_{0,02}$.

4. Phosphoreszierender Leuchtstoff gemäß Anspruch 2, dargestellt durch $Sr_{0,90}Mg_{0,05}Zn_{0,05}Al_2O_4{:}Eu_{0,035}Dy_{0,025}$.

5. Phosphoreszierender Leuchtstoff gemäß Anspruch 1, dargestellt durch $Sr_{0,905}Mg_{0,04}Al_2O_4{:}Eu_{0,01}Dy_{0,03}$.

6. Verfahren zur Herstellung des phosphoreszierenden Leuchtstoffs gemäß einem der Ansprüche 1, 3 und 5, wobei das Verfahren umfasst:

einen Schritt des Mischens von einem Rohmaterial, umfassend ein Strontium-Element, einem Rohmaterial, umfassend ein Magnesium-Element, Aluminiumoxid, optional einem Rohmaterial, umfassend ein Europium-Element, und optional einem Rohmaterial, umfassend mindestens ein Element, das aus der Gruppe ausgewählt ist, die aus Dysprosium, Samarium, Lanthan, Praseodym, Terbium, Holmium, Thulium, Lutetium, Ytterbium, Erbium, Gadolinium, Neodym und Cer besteht, um eine Mischung bereitzustellen; und einen Schritt des Sinterns der Mischung in einem Bereich von 1200°C bis 1700°C.

7. Verfahren zur Herstellung des phosphoreszierenden Leuchtstoffs gemäß einem der Ansprüche 2 und 4, wobei das Verfahren umfasst:

einen Schritt des Mischens von einem Rohmaterial, umfassend ein Strontium-Element, einem Rohmaterial, umfassend ein Magnesium-Element, Aluminiumoxid, optional einem Rohmaterial, umfassend ein Europium-Element, optional einem Rohmaterial, umfassend mindestens ein Element, das aus der Gruppe ausgewählt ist, die aus Dysprosium, Samarium, Lanthan, Praseodym, Terbium, Holmium, Thulium, Lutetium, Ytterbium, Erbium, Gadolinium, Neodym und Cer besteht, und einem Rohmaterial, umfassend ein Zink-Element, um ein Gemisch bereitzustellen; und einen Schritt des Sinterns der Mischung in einem Bereich von 1200°C bis 1700°C.

8. Verfahren zur Herstellung des phosphoreszierenden Leuchtstoffs gemäß Anspruch 6 oder 7, wobei in dem Schritt des Bereitstellens des Gemischs auch Boroxid beigemischt wird.

9. Phosphoreszierendes Produkt, umfassend den phosphoreszierenden Leuchtstoff gemäß einem der Ansprüche 1 bis 5.

**Revendications**

1. Phosphore phosphorescent représenté par la formule de composition (1) suivante :

$$Sr_{1-a}Mg_bAl_2O_4{:}Eu_dM_e ... \qquad (1)$$

dans lequel a, b, d, et e satisfont $(b + d + e) < a$, $0,05 \leq a \leq 0,8$, $0,01 \leq b < 0,1$, $0 \leq d \leq 0,2$, et $0 \leq e \leq 0,15$, respectivement, et M représente au moins un élément choisi dans le groupe consistant en le dysprosium, le samarium, le lanthane, le praséodyme, le terbium, l'holmium, le thulium, le lutétium, l'ytterbium, l'erbium, le gadolinium, le néodyme et le cérium ;
dans lequel le phosphore phosphorescent émet une lumière sous l'effet d'une lumière d'excitation de région de longueur d'onde de 430 à 480 nm.

2. Phosphore phosphorescent représenté par la formule de composition (1) suivante :

$$Sr_{1-a}Mg_bZn_cAl_2O_4 ;Eu_dM_e ... \qquad (1)$$

dans lequel a, b, c, d, et e satisfont $0,05 \leq a \leq 0,8$, $0,01 \leq b < 0,1$, $0,01 \leq c \leq 0,2$, $0 \leq d \leq 0,2$, et $0 \leq e \leq 0,15$, respectivement, et M représente au moins un élément choisi dans le groupe consistant en le dysprosium, le samarium, le lanthane, le praséodyme, le terbium, l'holmium, le thulium, le lutétium, l'ytterbium, l'erbium, le gadolinium, le néodyme et le cérium ;
dans lequel le phosphore phosphorescent émet une lumière sous l'effet d'une lumière d'excitation de région de longueur d'onde de 430 à 480 nm.

3. Phosphore phosphorescent selon la revendication 1, représenté par $Sr_{0,89}Mg_{0,04}Al_2O_4 ;Eu_{0,04}Dy_{0,02}$.

4. Phosphore phosphorescent selon la revendication 2, représenté par $Sr_{0,90}Mg_{0,05}Zn_{0,05}Al_2O_4 ;Eu_{0,035}Dy_{0,025}$.

5. Phosphore phosphorescent selon la revendication 1, représenté par $Sr_{0,905}Mg_{0,04}Al_2O_4 ;Eu_{0,01}Dy_{0,03}$.

6. Procédé de fabrication du phosphore phosphorescent selon l'une quelconque des revendications 1, 3 et 5, le procédé comprenant :

une étape consistant à mélanger une matière première comprenant un élément de strontium, une matière première comprenant un élément de magnésium, une alumine, facultativement une matière première comprenant un élément d'europium, et facultativement une matière première comprenant au moins un élément choisi dans le groupe consistant en le dysprosium, le samarium, le lanthane, le praséodyme, le terbium, l'holmium, le thulium, le lutétium, l'ytterbium, l'erbium, le gadolinium, le néodyme et le cérium, pour fournir un mélange ; et
une étape de frittage du mélange dans une plage de 1 200 °C à 1 700 °C.

7. Procédé de fabrication du phosphore phosphorescent selon l'une quelconque des revendications 2 et 4, le procédé comprenant :

une étape consistant à mélanger une matière première comprenant un élément de strontium, une matière première comprenant un élément de magnésium, une alumine, facultativement une matière première comprenant un élément d'europium, facultativement une matière première comprenant au moins un élément choisi dans le groupe consistant en le dysprosium, le samarium, le lanthane, le praséodyme, le terbium, l'holmium, le thulium, le lutétium, l'ytterbium, l'erbium, le gadolinium, le néodyme et le cérium, et une matière première comprenant un élément de zinc, pour fournir un mélange ; et
une étape de frittage du mélange dans une plage de 1 200 °C à 1 700 °C.

8. Procédé de fabrication du phosphore phosphorescent selon la revendication 6 ou 7, dans lequel un oxyde de bore est également mélangé dans l'étape de fourniture du mélange.

9. Produit phosphorescent comprenant le phosphore phosphorescent selon l'une quelconque des revendications 1 à 5.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6267911 B1
- JP 2543825 B
- US 2011155428 A
- JP 4932189 B

**Non-patent literature cited in the description**

- **H. RYU et al.** *The Open Applied Physics Journal,* 2009, vol. 2, 1-4
- **K.S. BARTWAL et al.** *Physica B,* 2009, 3440-3444
- **K.S. BARTWAL.** *Optical Materials,* 2010, vol. 32, 1329-1332
- **F. YANG et al.** *Journal of the Chinese Rare Earth Society,* 2008, vol. 26, 561-565